# FASCICULE DE BREVET EUROPEEN

(11) **EP 2 808 105 B1**
(45) Date de publication et mention de la délivrance du brevet: **12.07.2017**
(21) Numéro de dépôt: 14170344.7
(22) Date de dépôt: 28.05.2014
(51) Int. Cl.: B22F 1/00, B22F 9/04, B22F 9/24, C30B 1/12, C30B 29/02, C22C 21/00, C30B 29/60, C30B 30/06, C30B 33/06, H01L 21/00

(54) **Procede thermo acoustique de fabrication de nanoparticules monocristallines d'aluminium.**
Thermoakustisches Verfahren zur Herstellung von monokristallinen Nanoteilchen aus Aluminium
Thermoacoustic method for manufacturing monocrystalline aluminium nanoparticles

(30) Priorité: 30.05.2013 FR 1354932; 02.10.2013 FR 1359537
(43) Date de publication de la demande: 03.12.2014
(73) Titulaire: Université de Technologie de Troyes, 10010 Troyes Cédex (FR)
(72) Inventeur: Plain, Jérôme, 10000 TROYES (FR); Proust, Julien, 10300 SAINT SAVINE (FR); Schuermans, Silvère, 10190 BERCENAY EN OTHE (FR); Martin, Jérôme, 10150 CRENEY-PRES-TROYES (FR)
(74) Mandataire: Chaffraix, Jean

(56) Documents cités:
- US-A1- 2010 314 578
- CHARALAMPOS MANDILAS ET AL: "Synthesis of aluminium nanoparticles by arc plasma spray under atmospheric pressure", MATERIALS SCIENCE AND ENGINEERING: B, vol. 178, no. 1, 25 octobre 2012 (2012-10-25), pages 22-30, XP055104927, ISSN: 0921-5107, DOI: 10.1016/j.mseb.2012.10.004
- KUMAR BHUPESH ET AL: "Synthesis of nanoparticles in laser ablation of aluminum in liquid", JOURNAL OF APPLIED PHYSICS, AMERICAN INSTITUTE OF PHYSICS, 2 HUNTINGTON QUADRANGLE, MELVILLE, NY 11747, vol. 108, no. 6, 21 septembre 2010 (2010-09-21), pages 64906-64906, XP012143030, ISSN: 0021-8979, DOI: 10.1063/1.3486517

## Description

### DOMAINE TECHNIQUE DE L'INVENTION

L'invention se rapporte au domaine des nanoparticules d'aluminium. Un procédé de fabrication de type thermo-acoustique, à la fois simple, fiable et peu coûteux est visé par l'invention.

### ETAT DE LA TECHNIQUE ANTERIEURE

On connait des techniques de fabrication de nanoparticules d'aluminium telles que la lithographie par interférence dans l'ultra-violet, la lithographie par nanosphères ou la lithographie à faisceau d'électrons. Ces techniques nécessitent une étape d'évaporation du métal et la quantité de nanoparticules produites est faible (typiquement quelques unités par micromètre carré).

Par ailleurs l'évaporation du métal à travers des nano-trous conduit à des nanostructures non-uniformes, avec des largeurs de résonances à plasmon de surface dégradées, dues à une faible cristallinité. On sait aussi que l'ablation laser permet de créer des nanoparticules cristallines ; cependant leur dispersion dimensionnelle est forte, ce qui conduit à un faible contrôle de leurs propriétés plasmoniques.

Dès que l'on cherche à fabriquer des nanoparticules de faibles dimensions c'est-à-dire de taille inférieure à une dizaine de nanomètres, les coûts sont importants, ce qui limite l'intérêt en termes d'applications. Par ailleurs la matière elle-même, par exemple de l'or ou de l'argent représente un coût qui peut être dissuasif.

Il est donc d'un intérêt croissant de proposer des nanoparticules peu chères qui présentent des propriétés optiques et électroniques intéressantes. A ce titre l'aluminium apparait comme très intéressant : il présente une constante diélectrique dont la partie réelle reste négative jusqu'à 100 nm de longueur d'onde tout en conservant une faible absorption, ce qui autorise des résonances plasmoniques de surface de haute énergie. L'aluminium présente en outre des propriétés électroniques très spécifiques avec notamment des transitions interbande dans une zone d'énergies centrée autour de 1.5 eV. En dehors de cette zone, l'aluminium se comporte comme un matériau de type Drude avec de faibles pertes inter-bande et il peut supporter des résonances de plasmons de surface bien définies, de l'UV profond au bleu.

De plus ce métal est chimiquement stable : une fine couche d'oxydation, stable et transparente, épaisse de quelques nanomètres seulement, se forme naturellement à sa surface. Cet oxyde agit comme une couche de passivation qui empêche toute oxydation plus profonde et qui stabilise l'indice optique environnant. Ainsi l'aluminium apparait très intéressant pour étendre la gamme spectrale des résonances plasmons vers les ultra-violets.

Le document intitulé « Synthesis of aluminium nanoparticles by arc plasma spray under atmospheric pressure » de CHARALAMPOS MANDILAS et Al paru le 1er janvier 2013 dans Materials Science and Engineering, concerne la synthèse de nanoparticules d'aluminium à partir de poudre d'aluminium de taille micronique, par une technique de pulvérisation atmosphérique appropriée. La synthèse de nanoparticules peut être réalisée par mélange et vaporisation des particules initiales de taille micronique, et leur re-nucleation.

La demande US 2012/0314578 divulgue une méthode selon laquelle on mélange un ou plusieurs matériaux initiaux d'halogénures métalliques, un ou plusieurs agents réducteurs de lithium et un ou plusieurs solvants. Les nanoparticules obtenues par cette méthode sont pures et présentent une structure creuse et poreuse.

Le document intitulé « Synthesis of nanoparticules in laser ablation of aluminium in liquid » de KUMAR BHUPESH et Al paru le 21 septembre 2010 dans la revue ' Journal of applied Physics ' illustre un procédé de synthèse de nanoparticules par ablation laser dans de l'eau.

### EXPOSE DE L'INVENTION

L'invention vise à remédier aux inconvénients de l'état de la technique et notamment à proposer des nanoparticules d'aluminium aux propriétés optiques et électroniques améliorées, ainsi qu'un procédé de fabrication de telles nanoparticules.

L'invention vise notamment le procédé de fabrication selon la revendication 1.

Ce procédé est donc basé sur une fragmentation de feuilles d'aluminium du commerce, par passage dans un dispositif à ultrasons préférentiellement chauffé à 70°C.

Spécifiquement, le solvant utilisé lors de l'étape a) est préférentiellement de l'éthylène glycol pur à 99.9%.

En particulier, l'étape (b) comprend la décantation de la composition obtenue, de préférence pendant environ 24 h afin de stratifier les nanoparticules par tailles.

De préférence, l'étape (d) comprend la centrifugation de la composition obtenue de préférence pendant environ 2 mn avec une force centrifuge relative (FCR) d'environ 1400

L'invention porte également sur une composition de nanoparticules d'aluminium obtenue par un procédé tel que décrit précédemment. Ces compositions comprennent des nanoparticules dont la taille présente une répartition homogène. En particulier ces compositions comprennent des nanoparticules dont la taille est répartie suivant une courbe de Gauss, ou deux courbes de Gauss qui se recoupent.

Les nanoparticules monocristallines d'aluminium obtenues par un tel procédé, de forme sphérique, de tailles comprises entre 2 nm et 200 nm, font partie de l'invention. De façon spécifique, leurs propriétés optiques dans les longueurs d'ondes des ultra-violets sont telles qu'elles présentent au moins deux pics d'extinction de sorte qu'elles constituent des sources de lumière fortement énergétiques. L'extinction est mesurée dans une solution adaptée telle qu'une solution d'hexane, d'éthylène glycol ou de dodécane.

De manière surprenante, ces nanoparticules présentent des propriétés d'émission, de type électroluminescence, très intéressantes.

Selon un autre aspect de l'invention, les nanoparticules présentent un pic de photoluminescence selon la revendication 5.

### BREVE DESCRIPTION DES FIGURES

D'autres caractéristiques et avantages de l'invention ressortiront à la lecture de la description qui suit, en référence aux figures annexées, qui illustrent :
- la figure 1, un histogramme normalisé de la dispersion relative au diamètre des nanoparticules obtenues selon un procédé chimique ;
- la figure 2, un histogramme normalisé de la dispersion relative au diamètre des nanoparticules obtenues selon un procédé thermo acoustique conforme à l'invention ;
- la figure 3, une courbe relative à l'extinction en fonction des longueurs d'onde λ pour des nanoparticules obtenues selon un procédé chimique ;
- la figure 4, une courbe relative à l'extinction en fonction des longueurs d'onde λ pour des nanoparticules obtenues par un procédé thermo acoustique conforme à l'invention ;
- la figure 5, un schéma d'une installation permettant de caractériser les nanoparticules ;
- la figure 6, deux courbes comparatives de l'intensité lumineuse de nanoparticules d'or et d'aluminium, excitées à une longueur d'onde λ du domaine des UV ;
- la figure 7, un spectre d'excitation obtenu pour des nanoparticules d'aluminium de diamètres compris entre 2 et 5 nm ;
- la figure 8, un spectre d'excitation obtenu pour des nanoparticules d'or de diamètres compris entre 2 et 3 nm ; et
- la figure 11, un schéma des étapes du procédé thermo-acoustique mis en oeuvre selon l'invention.

Pour plus de clarté, les éléments identiques ou similaires sont repérés par des signes de référence identiques sur l'ensemble des figures.

### DESCRIPTION DETAILLEE D'UN MODE DE REALISATION

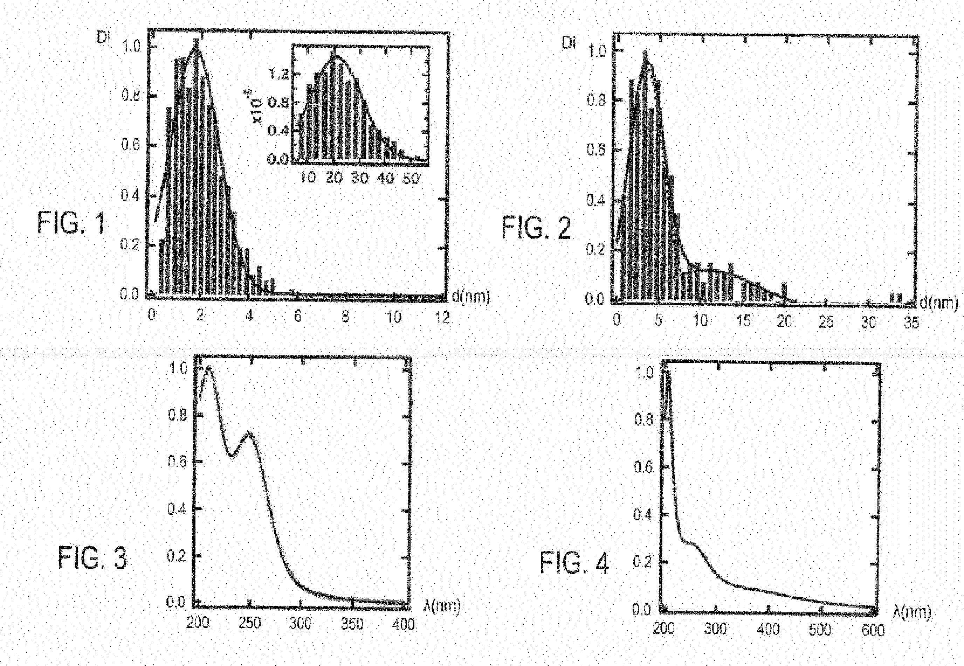

Les histogrammes des figures 1 et 2 mettent en relief une faible dispersion des mesures des diamètres des nanoparticules d'aluminium : selon la figure 1, obtenue avec une population d'environ 1200 nanoparticules, le diamètre moyen est de l'ordre de 2 nm. Selon la figure 2, obtenue avec environ 250 nanoparticules, deux familles de nanoparticules sont distinguées : la première concerne des tailles d'environ 3.5 nm et la seconde est relative à la présence de nanoparticules de diamètres compris entre 10 et 20 nm. La méthode thermoacoustique conforme à l'invention, telle qu'elle sera explicitée ci-dessous, permet de comprendre la présence de ces deux familles.

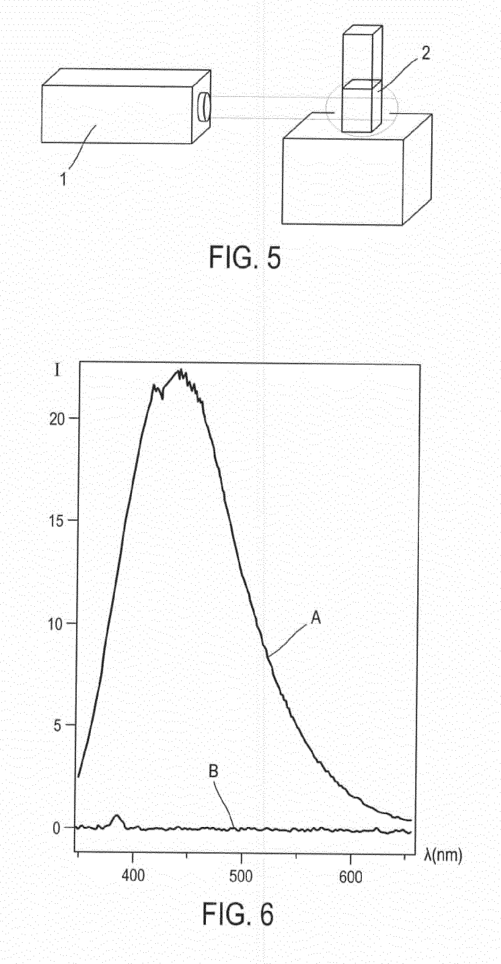

Les propriétés optiques des nanoparticules selon l'invention sont caractéristiques et les figures 3 et 4 en font apparaitre certaines, en particulier en ce qui concerne l'extinction. Les mesures d'extinction ont été réalisées sur des solutions contenant des nanoparticules : la figure 3 avec une solution d'hexane et la figure 4 avec une solution d'éthylène glycol. Il est encore possible, sans sortir du cadre de l'invention, d'utiliser une solution de dodecane, chauffée préférentiellement à 75°C. Comme schématisé sur la figure 5, un spectromètre 1 opérant dans des longueurs d'onde λ comprises entre 200 et 600 nm est utilisé. Le faisceau est dirigé vers un contenant 2 renfermant la solution qui contient les nanoparticules. Sur les spectres d'extinction de la figure 3, on voit un premier pic à environ 206 nm et un deuxième pic autour de 250 nm, ce qui révèle la présence d'excitations de résonance à plasmon de surface des nanoparticules. Le premier pic correspond à l'extinction des particules ayant un diamètre de l'ordre de 2 nm (résonance plasmonique également) tandis que le second pic correspond à la 'résonance plasmonique principale', pour les nanoparticules ayant un diamètre d'environ 20nm.

Si l'on considère la figure 4, ce spectre d'extinction fait apparaitre plusieurs pics : le premier pour une longueur d'onde λ centrée à 207 nm correspond à la résonance des nanoparticules de plus petit diamètre, en l'occurrence d'environ 3.5 nm (cf figure 2) ; le second pic situé à 254 nm correspond à la résonance des particules ayant un diamètre d'environ 11 nm. Un troisième pic peut être vu, vers 389 nm. Il s'agit de la résonance des particules de diamètres plus importants que les précédents, ici de 35 ou de 70 nm.

La figure 6 illustre la photoluminescence de nanoparticules, respectivement d'or et d'aluminium, sous une excitation de 340 nm. La courbe A concerne la réponse des nanoparticules d'aluminium tandis que la courbe B correspond aux nanoparticules d'or. On voit nettement que les nanoparticules d'or présentent une intensité lumineuse quasi nulle et stable, sans pic notable. De façon bien différente les nanoparticules d'aluminium présentent une photoluminescence non constante, avec un pic nettement formé vers 450 nm. Cette figure met en relief l'intérêt des nanoparticules d'aluminium obtenues selon l'invention.

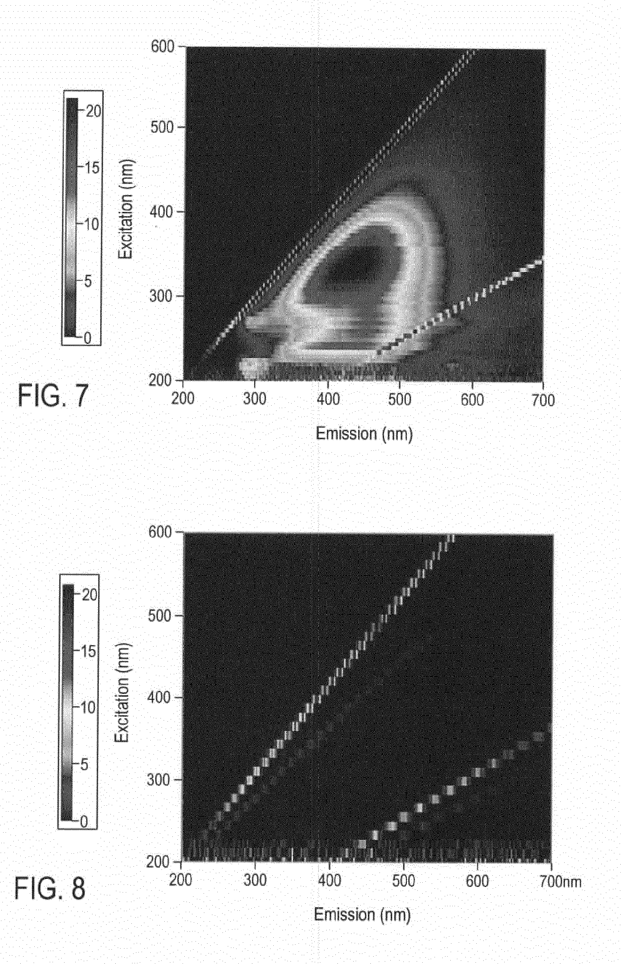

Cette propriété est par ailleurs mise en exergue par les figures 7 et 8 qui montrent des spectres d'excitation pour respectivement des particules d'aluminium (figure 7) et d'or (figure 8). Dans les mêmes conditions (notamment pour des tailles similaires) et plages d'émission, l'excitation des particules d'aluminium est très nettement visible sur la figure 7 ; au contraire sur la figure 8 aucune réponse n'apparait. Ceci démontre clairement l'excellente photoluminescence des particules d'aluminium obtenues selon l'invention.

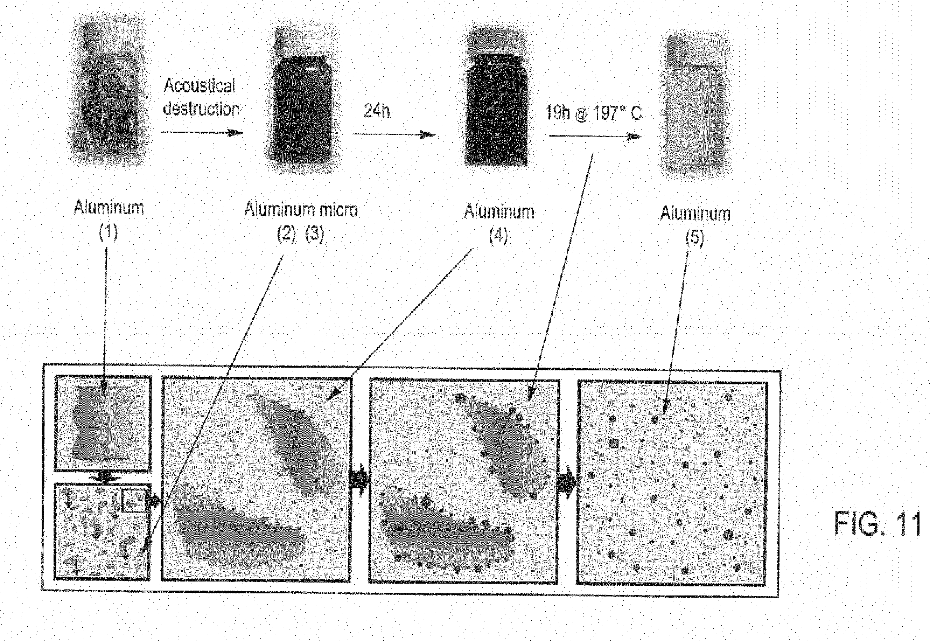

La figure 11 illustre la synthèse de particules d'aluminium par un procédé thermo-acoustique conforme à l'invention. Ce procédé est fondé sur la fragmentation de feuilles d'aluminium. On a fragmenté des morceaux de feuilles du commerce, pesant 35 mg et ayant une épaisseur de 30µm, par implosion de bulles de cavitation à sa surface. Les feuilles sont immergées dans 10 mL de solvant et soumises pendant trente heures à une température de 70 °C. L'implosion des bulles crée une énergie correspondant à une pression locale appliquée sur la feuille, entre 150 bars et 10000 bars, ce qui explique la fragmentation. Le niveau de cavitation dépend de la température et de la viscosité du milieu. Plus la température croît, plus la viscosité décroît, ce qui améliore la formation de bulles de cavitation. Cependant l'augmentation de la température accroît la quantité de gaz dissout dans le milieu. Si une bulle de cavitation entre en contact avec une bulle de gaz, elle n'implose pas. Ainsi le point d'ébullition du solvant doit être suffisamment haut pour éviter la formation de bulles de gaz à la température de chauffage du bain sonique, ici fixé à 70°C.

En conséquence l'éthylène glycol a été choisi comme solvant, à cause de son point d'ébullition à 197°C. Il est ici nécessaire de préciser que la fragmentation dépend de la fréquence sonique ainsi que du ratio entre la puissance acoustique et la surface du bain ultrasonique.

## Revendications

1. Procédé de fabrication par synthèse thermo-acoustique de nanoparticules d'aluminium de forme sphériques, de tailles comprises entre 2 nm et 200 nm, dont les propriétés optiques dans les longueurs d'ondes des ultra-violets sont telles qu'elles présentent au moins deux pics d'extinction de sorte qu'elles constituent des sources de lumière fortement énergétique **caractérisé en ce qu'**il comprend les étapes successives consistant à : -a) fragmenter à l'aide d'ultrasons une feuille d'aluminium d'épaisseur micronique, la feuille d'aluminium étant immergée et chauffée dans un solvant dont la température d'ébullition est supérieure ou égale à 150°C, dans un intervalle de temps compris entre 10 et 100 heures, de préférence 30 h, à une température comprise entre 0°C et 100°C, de préférence 70 °C, et les ultrasons étant à une fréquence comprise entre 20 KHz et 50 KHz, de préférence de l'ordre de 37 KHz, pour obtenir des microfeuilles -b) de préférence séparer les microfeuilles de taille comprise entre 50 nm et 20 µm - c) recuire les microfeuilles à une température comprise entre 150°C et la température d'ébullition du solvant, de préférence environ 197°C pendant 10 à 100 h, de préférence 19 h - d) purifier la solution obtenue pour récupérer les nanoparticules d'aluminium et **en ce que** l'extinction est mesurée dans une solution d'hexane, d'éthylène glycol ou de dodécane.

2. Procédé selon la revendication précédente **caractérisé en ce que** le solvant utilisé lors de l'étape a) est de l'éthylène glycol pur à 99.9%.

3. Procédé selon l'une des revendications précédentes **caractérisé en ce que** l'étape b) comprend la décantation de la solution obtenue de préférence pendant environ 24 h, afin de stratifier les nanoparticules par tailles.

4. Procédé selon l'une des revendications précédentes **caractérisé en ce que** l'étape d) comprend la centrifugation de la solution de préférence pendant environ 2 mn avec une force centrifuge relative (FCR) d'environ 1400.

5. Nanoparticules obtenues par un procédé selon l'une des revendications 1 à 4 **caractérisées en ce qu'**elles présentent un pic de photoluminescence à une

## Patentansprüche

1. Verfahren zur Herstellung kugelförmiger Aluminium-Nanopartikel in einer Größe zwischen 2 nm und 200 nm durch thermoakustische Synthese, wobei deren optische Eigenschaften in den Wellenlängen der UV-Strahlen dergestalt sind, dass sie mindestens zwei Extinktionspeaks aufweisen, so dass sie stark energetische Lichtquellen bilden, **dadurch gekennzeichnet, dass** es aufeinander folgende Schritte umfasst, die darin bestehen:
- a) eine Aluminiumfolie in Mikrondicke mit Hilfe von Ultraschall zu fragmentieren, wobei die Aluminiumfolie über einen Zeitraum zwischen 10 und 100 Stunden, vorzugsweise 30 Stunden, bei einer Temperatur zwischen 0°C und 100°C, vorzugsweise 70°C, in ein Lösungsmittel eingetaucht bzw. darin erhitzt wird, dessen Siedetemperatur größer/gleich 150°C ist, wobei der Ultraschall eine Frequenz von 20 KHz und 50 KHz, vorzugsweise aber um 37 KHz aufweist, um Mikrofolien zu erhalten,
- b) vorzugsweise die Mikrofolien in einer Größe zwischen 50 nm und 20 µm zu trennen
- c) die Mikrofolien bei einer Temperatur zwischen 150°C und der Siedetemperatur, vorzugsweise ungefähr 197°C, 10 bis 100 Stunden, vorzugsweise 19 Stunden lang, zu glühen,
- d) die erhaltene Lösung zu reinigen, um die Aluminiumnanopartikel zu erhalten, und dadurch, dass die Extinktion in einer Hexan-, Ethylenglykol- oder Dodecanlösung gemessen wird.

2. Verfahren nach dem vorhergehenden Anspruch, **dadurch gekennzeichnet, dass** das in Schritt a) benutzte Lösungsmittel zu 99,9% reines Ethylenglykol ist.

3. Verfahren nach einem der vorhergehenden Ansprüche, **dadurch gekennzeichnet, dass** Schritt b) das Dekantieren der erhaltenen Lösungen über eine Dauer von vorzugsweise 24 Stunden umfasst, um die Nanopartikel nach Größen zu schichten.

4. Verfahren nach einem der vorhergehenden Ansprüche, **dadurch gekennzeichnet, dass** Schritt d) die Zentrifugation der Lösung über eine Dauer von vorzugsweise ungefähr 2 Min. mit einer relativen Zentrifugalkraft (RZK) von ungefähr 1400 umfasst.

5. Nanopartikel, die durch ein Verfahren nach einem der Ansprüche 1 bis 4 hergestellt wurden, **dadurch gekennzeichnet, dass** sie einen Photolumineszenzpeak bei einer Länge von 460 Nm aufweisen.

## Claims

1. A thermo-acoustic synthesis method for manufacturing aluminum nanoparticles, having a substantially spherical shape and a size ranging from 2nm to 200nm, the optical properties of which in the ultraviolet wavelengths are such that they have at least two extinction peaks so that they are high energy light sources, **characterized in that** it comprises the following successive steps consisting in:
- a) fragmenting an aluminum foil having a micronic thickness, using ultrasound, with the aluminum foil being immersed and heated in a solvent, the boiling temperature of which is higher than or equal to 150°C, in a time interval ranging from 10 to 100 hours, preferably 30 hours, at a temperature between 0°C and 100°C, preferably 70°C, and the ultrasound being at a frequency between 20KHz and 50KHz, preferably of about 37KHz in order to obtain micro-foils
- b) preferably separating the micro-foils having a size ranging from 50nm to 20µm
- c) annealing the micro-foils at a temperature between 150°C and the boiling temperature of the solvent, preferably about 197°C for 10 to 100hrs, preferably 19hrs
- d) purifying the solution obtained to collect the aluminum nanoparticles and **in that** the extinction is measured in a solution of hexane, ethylene glycol or dodecane.

2. A method according to the preceding claim **characterized in that** the solvent used in step a) is 99.9% pure ethylene glycol.

3. A method according to one of the preceding claims **characterized in that** step b) comprises the settling of the solution obtained preferably for about 24hrs in order to stratify the nanoparticles by size.

4. A method according to one of the preceding claims, **characterized in that** step d) comprises the centrifuging of the solution preferably for about 2min with a relative centrifugal force (RCF) of about 1,400.

5. Nanoparticles obtained using a method according to one of claims 1 to 4, **characterized in that** they exhibit a photoluminescence peak at a wavelength of 460nm.
